# EUROPEAN PATENT APPLICATION

(11) **EP 0 696 055 A2**
(43) Date of publication of application: **07.02.1996**
(21) Application number: 95303811.4
(22) Date of filing: 05.06.1995
(51) Int. Cl.: H01L 21/60

(54) **Electronic assemblies and methods of treatment**

(30) Priority: 27.07.1994 GB 9415108
(71) Applicant: Smiths Industries Public Limited Company, London, NW11 8DS (GB)
(72) Inventor: Maloney, Conrad Raymond Crewe, Cheltenham, Gloucestershire GL 51 8JT (GB); Cannon, Kevin Melvyn, Cheltenham, Gloucestershire (GB)
(74) Representative: Flint, Jonathan McNeill

(57) **Abstract**

An integrated circuit die 2 has exposed regions on its upper surface of aluminium on which forms an oxide layer 13. The oxide layer 13 is etched away to form windows 12 onto the underlying aluminium regions 10. A conductive, protective layer 14 of titanium nitride is sputtered on the upper surface of the die; pads 7 of a conductive thermoplastic 15 are then deposited over the windows 12. The titanium nitride layer 14 is subsequently removed by etching, except where it is protected by the pads 7. The die 2 can then be flipped over and joined to a substrate 1 by making electrical connection between the pads 7 and conductive regions 8 on the substrate.

## Description

This invention relates to methods of the kind for treating an integrated circuit die having conductive metal regions exposed on a surface of the die such that a metal oxide layer has formed thereon.

With the increase in packing density of electronic integrated circuits, has come the need for reliable interconnection to smaller and more closely-packed contacts on the circuits. In flip-chip assemblies, the bonding pads of the integrated circuit or chip are distributed over its upper surface and these make contact with corresponding contacts on the upper surface of a substrate when the chip is inverted. Most flip-chip integrated circuits are formed with bumps, such as of solder, on their bonding pads. These bumps project below the flip-chip into contact with a conductive region of the substrate to which they make an electrical and mechanical bond.

One disadvantage of this is that the integrated circuit die requires specialized processing at the silicon manufacturing stage in order to apply solder-wettable layers and bumps to the bonding pads. The result of this is that the flip-chip assembly technique cannot be used with conventional dice that are not pre-bumped.

Suggestions have been made that integrated circuit dice can be connected to a substrate by means of anisotropic electroconductive adhesives, such as described in EP-A-0372880. These adhesives have a non-conductive epoxy solution containing conductive particles. The composition of the adhesives is selected such that, when spread in a layer between the substrate and die, there is conduction between the substrate and the die via individual ones of the particles but there is no conduction in the plane of the layer because the particles are so widely distributed that they do not form a continuous conductive path. Although this technique avoids the need to form solder bumps, it does have problems. In particular, where aluminium is used for metallization in the integrated circuit, an oxide layer will form on the bond pads after exposure to air. This layer of aluminium oxide is electrically insulating. In conventional assemblies, the oxide layer is broken through by the welding process used to make a wire bond to the pads. However, where electrical connection is to be by means of an adhesive, the oxide layer will remain intact and provide a poor contact. To ensure that a good contact is formed with an adhesive, it is necessary, therefore, for the integrated circuit dice to be specially processed at the manufacturing stage with bond pads of a material that does not form an insulating oxide layer.

It is an object of the present invention to provide an improved method of treating integrated circuit dice, an improved die and electronic assembly and an improved method of forming an assembly.

According to one aspect of the present invention there is provided a method of the above-specified kind characterised in that the method includes the steps of removing the metal oxide to form windows onto the underlying metal regions, depositing on the die a layer of a protective electrically-conductive material, depositing on the protective layer overlying the windows pads of an electrically-conductive material and removing the protective layer except in regions where it is protected by the conductive pads.

The electrically-conductive material may be titanium nitride and the pads may be of an electrically-conductive thermoplastic. The pads may be deposited by screen printing. The metal oxide is preferably removed by etching the entire surface of the die. The protective layer may be removed except where it is protected by the conductive pads by sputter or reactive ion etching or by chemical etching.

According to another aspect of the present invention there is provided a method of forming an electronic assembly comprising the steps of treating an integrated circuit die according to the above one aspect of the invention and joining the die to a substrate such that the conductive pads on the die make electrical connection with conductive regions on the substrate.

The conductive pads on the die and the conductive regions on the substrate may be of electrically-conductive thermoplastic material, electrical connection of the die with the substrate being effected by applying heat to cause the thermoplastic material to flow together and allowing the material to cool and form a bond between the die and the substrate. Alternatively, the conductive pads on the die may be joined to the conductive regions of the substrate by means of an anisotropic electrically-conductive adhesive.

An electronic assembly including an integrated circuit die, a method of treatment of the die and a method of forming the assembly, according to the present invention, will now be described, by way of example, with reference to the accompanying drawings, in which:
- Figure 1: is a sectional side elevation view of a part of the assembly;
- Figure 2: is a sectional side elevation view of a part of a chip before treatment;
- Figures 3 to 7: are sectional side elevation views illustrating various stages in the treatment of the chip;
- Figure 8: is a sectional side elevation view showing a step in assembly of the chip onto a substrate;
- Figures 9 and 10: illustrate two steps in an alternative method of assembly of the chip onto the substrate; and
- Figures 11 and 12: illustrate two steps in another alternative method of assembly of the chip onto the substrate.

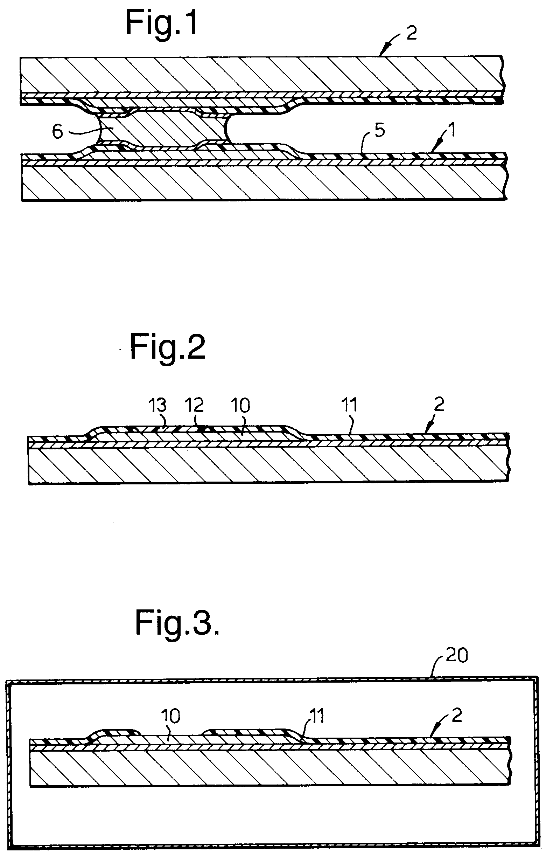

With reference to Figure 1, the assembly comprises a substrate 1 supporting several integrated circuit chips or dice 2, only one of which is shown. The chips 2 are turned upside down or "flipped" so that their upper surface faces downwards. The substrate 1 may be simple multi-layer interconnect device for interconnecting the chips 2 with one another or with external circuitry. Alternatively, the substrate itself may include active components such as transistors. The upper surface 5 of the substrate 1 is formed with conductive bumps bonded to corresponding bumps on the underside of the chips to form unitary bumps 6, which electrically and mechanically join the chips to the substrate.

The method by which the chip 2 is treated to produce its bumps will now be described with reference to Figure 2 to 7. Figure 2 shows the chip 2 as supplied by the manufacturer with an aluminium bond pad 10 on its upper surface. The surface of the chip 2 is covered by an insulating layer 11, which extends over the pad 10 except for an opening 12 through which the pad is exposed. As a result of the aluminium pad 10 being exposed to air through the opening 12, an insulating layer 13 of aluminium oxide is formed on the pad.

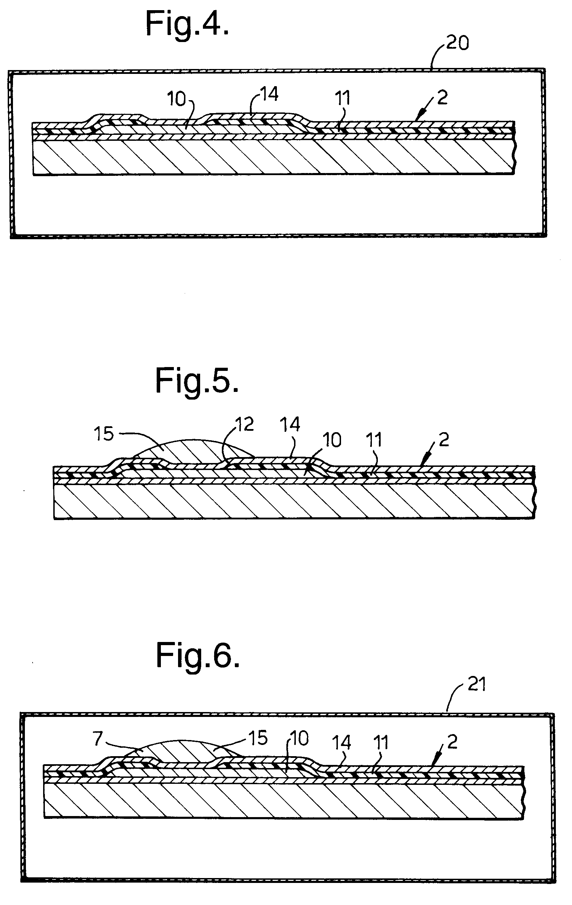

The first step is to place the chip 2 in a vacuum chamber 20, as shown in Figure 3, where the entire surface area of the chip is exposed to sputter or reactive ion etching to remove the oxide layer 13 and any other passivation layers on the chip, so that windows are provided at the openings 12 onto the underlying metal regions 10. Without removing the chip 2 from the vacuum chamber 20, a thin film 14 of titanium nitride is deposited, by sputtering, onto the entire upper surface of the chip. The film 14, as shown in Figure 4, forms a coating over the bond pad 10 and acts as a passivation material to protect it from oxidation. The film 14 is electrically conductive; other electrically-conductive protective materials could be used instead of titanium nitride.

The chip 2 is then removed from the vacuum chamber 20 and an electrically-conductive thermoplastic paste 15 is applied over the opening 12, as shown in Figure 5. The paste 15 could be screen printed onto the chip 2 or deposited in other ways, such as by dispensing from a syringe, which may be combined with computer-controlled x-y motor-driven stage.

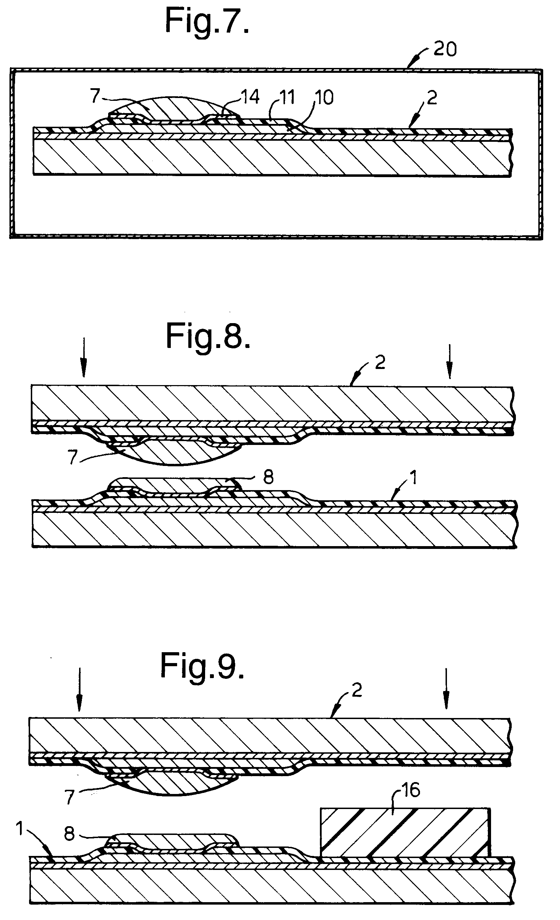

The chip 2 is then transferred to an oven 21 where it is heated to 150°C for 5 minutes to drive off carrier solvent in the paste 15, as shown in Figure 6. The temperature is then raised to 275°C for 15 minutes to improve adhesion of the paste. This temperature treatment hardens the paste 15 into conductive bumps 7. The barrier layer 14 electrically connects the bumps 7 with the pads 10 but also electrically connects the pads 10 with one another. The next step, therefore, is to remove the barrier layer 14 except for the regions where it is protected by the bumps 7. This can be done by a wet chemical etch, the bumps 7 being used as an etch definition mask to protect the underlying part of the layer 14. Preferably, however, the layer 14 is removed by sputter etching or reactive ion etching in the vacuum chamber 20, as shown in Figure 7. In this case, the bumps 7 act as sacrificial masks and lose a surface layer during the etching process. The chip 2 is now ready to be assembled on the substrate 1.

The chip 2 is aligned with the aid of split field optics and, or alternatively, by mechanical jigs so that the bumps 7 on the chip aligns with conductive bumps 8 on the substrate 1. The bumps 8 on the substrate 8 may be provided in the same way as the bumps 7 on the chip 2.

The chip 2 can be joined to the substrate 1 in various different ways. In one way, the chip 2 is lowered, as shown in Figure 8, so that its bumps 7 contact the bumps 8 on the substrate. Heat is applied to cause the thermoplastic of the bumps 7 and 8 to flow and then pressure is applied to force the bumps to combine. The assembly is allowed to cool, forming an electrical and mechanical bond at the bumps, as shown in Figure 1.

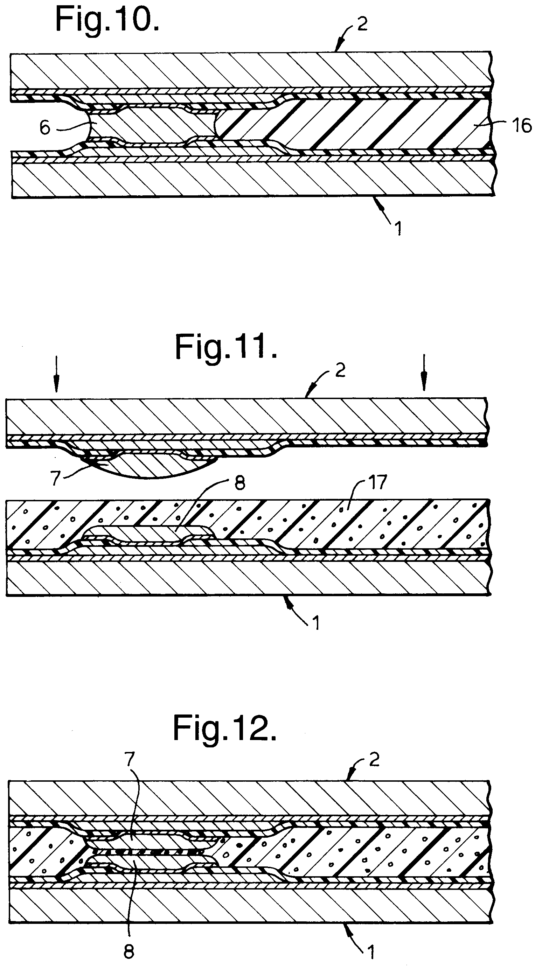

The mechanical and thermal bond between the chips 2 and the substrate 1 can be improved by applying an electrically-insulating adhesive 16 to the substrate or chips before the chips are brought down onto the substrate, as shown in Figures 9 and 10. When the chips 2 are lowered, the insulating adhesive 16 flows between them contacting the upper surface of the substrate and the lower surface of the chip, so as to improve the mechanical and thermal bond. This also reduces the risk of electrical shorts between adjacent bumps. Alternatively, or additionally, a pre-cut film of an electrically-insulating but thermally-conductive thermoplastic material could be applied to the region of the substrate between the bumps.

In another assembly technique, an anisotropic (Z-axis) electrically-conductive adhesive is used, as shown in Figures 11 and 12. The adhesive 17 is applied as a thin layer over the entire surface of the substrate 1 and the chips 2 are lowered onto the substrate. The application of pressure in the region between the bumps 7 and 8 creates contact of the bumps with conductive particles in the adhesive 17. The temperature is then raised to cure the adhesive and create an electrical and mechanical bond.

It can be seen that the present invention enables conventional integrated circuit dice to be treated and modified alter manufacture to provide them with conductive bumps suitable for use in flip-chip assembly.

## Claims

1. A method of treating an integrated circuit die (2) having conductive metal regions (10) exposed on a surface of the die such that a metal oxide layer (13) has formed thereon, characterised in that the method includes the steps of removing the metal oxide (13) to form windows onto the underlying metal regions (10), depositing on the die (2) a layer (14) of a protective electrically-conductive material, depositing on the protective layer (14) overlying the windows (12) pads (15) of an electrically-conductive material and removing the protective layer (14) except in regions where it is protected by the conductive pads (15).

2. A method according to Claim 1, characterised in that the electrically-conductive material (14) is titanium nitride.

3. A method according to Claim 1 or 2, characterised in that the pads (15) of electrically-conductive material are of an electrically-conductive thermoplastic.

4. A method according to any one of the preceding claims, characterised in that the pads (15) are deposited by screen printing.

5. A method according to any one of the preceding claims, characterised in that the metal oxide (13) is removed by etching the entire surface of the die (2).

6. A method according to any one of the preceding claims, characterised in that the protective layer (14) is removed except where it is protected by the conductive pads (15) by sputter or reactive ion etching.

7. A method according to any one of Claims 1 to 5, characterised in that the protective layer (14) is removed except where it is protected by the conductive pads (15) by chemical etching.

8. A method of forming an electronic assembly comprising the steps of treating an integrated circuit die (2) according to any one of the preceding claims and joining the die (2) to a substrate (1) such that the conductive pads (15) on the die (2) make electrical connection with conductive regions (8) on the substrate (1).

9. A method according to Claim 8, characterised in that conductive pads (15) on the die (2) and the conductive regions (8) on the substrate (1) are of electrically-conductive thermoplastic material, and that electrical connection of the die (2) with the substrate (1) is effected by applying heat to cause the thermoplastic material to flow together and allowing the material to cool and form a bond between the die and the substrate.

10. A method according to Claim 8, characterised in that the conductive pads (15) on the die (2) are joined to the conductive regions (8) of the substrate (1) by means of an anisotropic electrically-conductive adhesive (17).
